# DEMANDE DE BREVET EUROPEEN

(11) **EP 2 843 451 A1**
(43) Date de publication de la demande: **04.03.2015**
(21) Numéro de dépôt: 14181763.5
(22) Date de dépôt: 21.08.2014
(51) Int. Cl.: G02B 6/42, G02F 1/025, H01L 31/0352, H01L 31/105

(54) **Procédé de fabrication d'une jonction PIN en arête et à zones dopées espacées, application à la fabrication de modulateurs électro-optiques et de photodétecteurs**

(30) Priorité: 26.08.2013 FR 1358170
(71) Demandeur: COMMISSARIAT A L'ENERGIE ATOMIQUE ET AUX ENERGIES ALTERNATIVES, 75015 Paris (FR)
(72) Inventeur: MENEZO, Sylvie, 38500 VOIRON (FR)
(74) Mandataire: Nony

(57) **Abrégé**

L'invention concerne un procédé de fabrication d'une jonction PIN en arête (20, 21) en matériau semi-conducteur.

Selon l'invention, on réalise un choix judicieux de définition de masques durs et d'enchaînement de formation des masques de résine pour l'implantation (dopage) et la gravure qui permet d'utiliser la technique de photo-lithographie usuelle malgré sa faible précision d'alignement (± 100nm) des masques par rapport aux zones situées en dessous.

Grâce au procédé selon l'invention, on obtient, à moindre coût et en un temps de réalisation plus faible par rapport à l'état de l'art, la formation d'une jonction PIN en arête, avec des zones dopées précisément espacées du bord de l'arête.

## Description

### Domaine technique

La présente invention concerne le domaine de la photonique intégrée sur silicium. La technologie employée est celle de la microphotonique sur silicium, qui est compatible avec la technologie microélectronique.

Elle a trait plus particulièrement à la réalisation d'une jonction PIN en arête, éventuellement formée dans un guide d'onde, et à zones dopées de type P et de type N espacées par rapport aux bords de l'arête.

La présente invention se rapporte plus particulièrement à un modulateur électro-optique mettant en oeuvre une telle jonction PIN dans un guide d'onde en arête, fabriqué entièrement en silicium. Le guide est adapté pour assurer le guidage de lumière aux longueurs d'ondes des télécommunications optiques, typiquement supérieures à 1,1 µm. Le modulateur électro-optique permet notamment de moduler la lumière qui le traverse sous l'effet d'un signal électrique de commande. Le modulateur peut fonctionner avec des signaux de commande électrique ayant des fréquences élevées, typiquement de l'ordre de plusieurs dizaines de GHz.

Le modulateur selon la présente invention met en oeuvre un guide d'onde optique en arête dont la section peut être submicronique. Une jonction PIN est formée dans ce guide en arête. Sous l'effet d'un signal de commande électrique, les porteurs (électrons/ trous) sont injectés dans la jonction PIN, et donc dans le guide d'onde. Cette injection de porteurs modifie l'indice effectif du champ optique se propageant dans le guide d'onde et par conséquent, provoque une variation de l'intensité du champ optique.

On précise ici qu'un modulateur électro-optique avec la jonction PIN selon l'invention fonctionne par injection de porteurs, contrairement à d'autres dont la jonction PN ou PIPIN est prévue pour un fonctionnement par déplétion de porteurs.

Bien que décrite en référence préférentiellement à l'application de modulateur électro-optique, la présente invention porte également sur la fabrication d'un photo-détecteur entièrement en germanium. Un photo-détecteur permet de convertir un signal optique qu'il reçoit en signal électrique, en particulier un signal optique modulé par un modulateur électro-optique.

D'ailleurs, le procédé selon l'invention peut servir à réaliser toute jonction PIN en arête et à zones dopées espacées de l'arête, qui est mise en oeuvre dans tout autre composant électronique.

### Etat de la technique

Un modulateur électro-optique est formé en utilisant un ou plusieurs guides d'onde permettant chacun de moduler une onde optique qui le traverse par variation de l'indice effectif du champ optique.

Il est connu ainsi des modulateurs mettant en oeuvre un (ou plusieurs) guide(s) d'onde en arête dans laquelle est formée une jonction PIN, les zones dopées P et N étant espacées des bords de l'arête, et permettant d'assurer l'injection des porteurs libres dans le guide d'onde en arête.

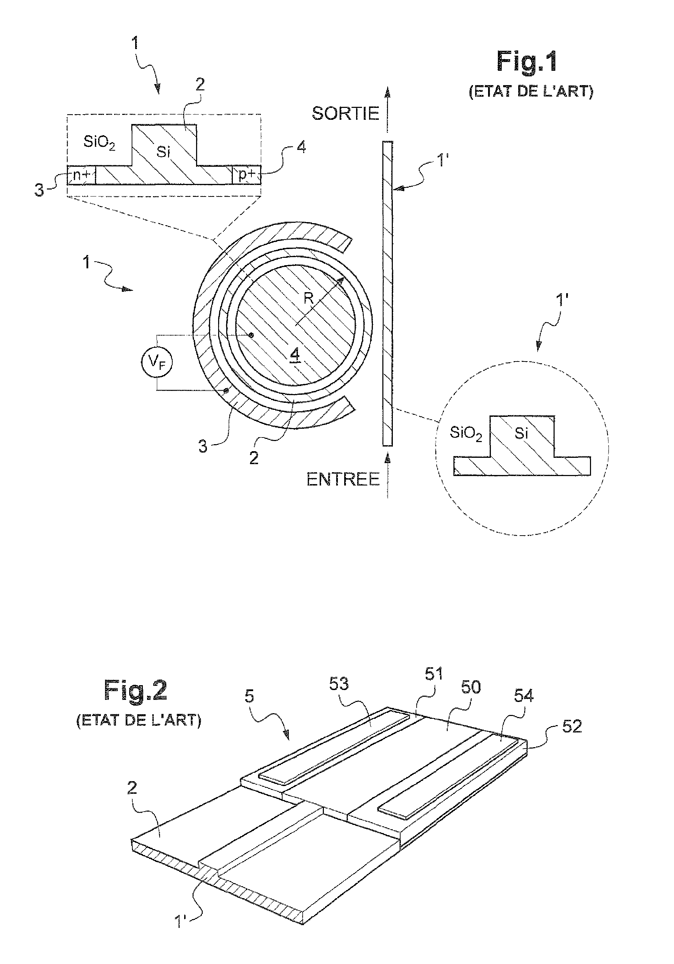

On peut citer la publication [1] qui décrit un micro-modulateur électro-optique à structure interférométrique en anneau, comportant un guide d'onde en arête dans laquelle est formée une jonction PIN. On a reproduit à la figure 1 un tel micro modulateur électro-optique.

Il est constitué d'un guide optique droit 1', et d'un guide optique 1 en anneau. La jonction PIN, ici N+IP+, est formée dans le guide d'onde en anneau 1, de structure en arête : la coupe transversale fait apparaitre les zones silicium dopées n+, non intentionnellement dopées, et dopées P+, respectivement notées, 3, 2 et 4. Les guides 1,1' sont espacés d'une distance e permettant un couplage du guide en anneau 1 vers le guide droit 1' et réciproquement. Comme mieux montré en figure de détail, le guide d'onde optique en anneau 1 est réalisé dans une structure de guide dite en arête réalisée en silicium et formée d'une zone 2 en silicium intrinsèque, i.e. non intentionnellement dopée, localisée entre une zone 3 en silicium dopé N+ et une zone en 4 en silicium dopé P+. Ce guide constitue ainsi une diode ou jonction PIN. Les zones 3 et 4 dopées sont formées dans une couche et la zone 2 intrinsèque présente une section transversale en forme d'arête.

Sous l'effet d'une polarisation de la diode PIN avec une tension VF, la concentration de porteurs par injection dans le guide 1 est modifiée. Cette modification induit un changement de l'indice effectif du guide d'onde vu par le champ optique qui s'y propage. A travers l'interféromètre en anneau, cette variation d'indice effectif est traduite en variation d'intensité du champ optique. Les auteurs de la publication [1] ont montré qu'une telle structure peut fonctionner jusqu'à des vitesses de modulation supérieures à 30GHz, moyennant une mise en forme temporelle de la tension de modulation VF.

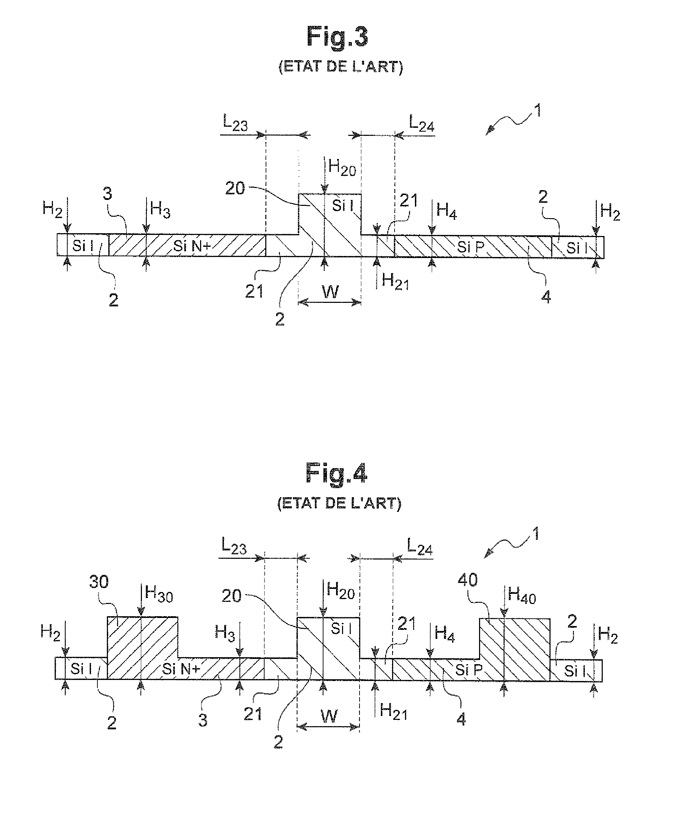

La publication [2] décrit un procédé de réalisation d'une telle jonction PIN dans un guide d'onde en arête avec ses zones dopées espacées, montrée plus en détail en figure 3. Avec les références indiquées sur la figure 3, l'arête 20 de la jonction PIN qui définit le guide d'onde optique doit avoir une largeur nominale W de 450nm et une hauteur nominale H20 de 250nm. Les largeurs nominales unitaires L₂₃ et L₂₄ de la dalle silicium 21 de part et d'autre de l'arête doivent être égales à 200nm. Le diamètre de l'anneau est de 12µm. L'espacement e entre le guide optique droit 1' et le guide optique en anneau 1 est de 200nm. Par ailleurs, du fait du procédé de fabrication selon la publication [2], les hauteurs respectivement H21 de dalle 21, H3, H4 de zones dopées 3, 4 et du silicium à l'extérieur de ces zones sont égales entre elles à 50 nm.

Pour obtenir de plus petites résistances d'accès à la jonction PIN, il est connu de réaliser des parties des zones dopées en remontées comme illustré en figure 4 : les remontées 30, 40 des zones dopées 3, 4 sont alors de même hauteur que l'arête 20, c'est-à-dire H₃₀=H₄₀=H₂₀.

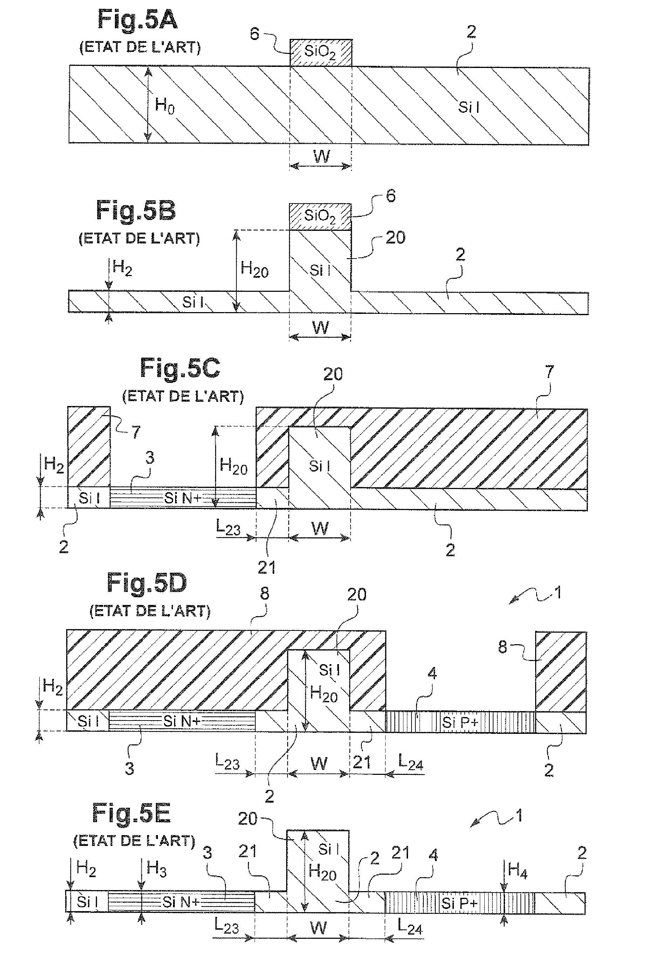

On décrit maintenant en relation avec les figures 5A à 5E, les différentes étapes de réalisation du procédé décrit dans la publication [2].

On forme tout d'abord sur la couche de silicium de hauteur initiale H0=H20, un masque de gravure 6 constitué d'une seule bande de largeur unitaire W qui définit la largeur de l'arête 20 du guide d'onde à réaliser (figure 5A). Cette étape de formation du masque dur 6 est réalisée par lithographie par faisceau d'électrons (« e-beam lithography » en anglais), étape longue et coûteuse.

Puis, on effectue la gravure sèche de la couche de silicium sur une profondeur donnée pour aboutir à la dalle mince de silicium de hauteur H2 (figure 5B). Cette hauteur H2 constitue la hauteur finale des zones dopées 3, 4 et de la dalle 21 de part et d'autre de l'arête 20. L'arête 20, quant à elle, présente une hauteur H20 égale à la hauteur initiale H0 de la couche 2.

On élimine alors le masque dur 6 puis on forme alors par photolithographie un premier masque de résine 7 sur la couche 2 mais en laissant dégagée une première zone 3 de couche 2 définissant une première zone d'implantation 3, celle-ci étant espacée d'une distance L₂₃ d'un bord de l'arête 20 (figure 5C).

On implante alors un dopant de type N+ dans la première zone d'implantation 3 (figure 5C). L'implantation du dopant de type N+ peut être réalisée avec du phosphore à une concentration de 10¹⁹ atomes par cm³.

Puis, une fois la première zone 3 dopée, on élimine le premier masque de résine 7.

On forme ensuite par photolithographie un deuxième masque de résine 8 sur la couche 2 et la zone dopée N+ mais en laissant dégagée une deuxième zone 4 de couche 2 définissant une deuxième zone d'implantation 4, celle-ci étant espacée d'une distance L₂₄ de l'autre bord de l'arête 20 (figure 5D).

On implante alors un dopant de type P dans la deuxième zone d'implantation (figure 5D). Le dopant de type P+ peut être du bore à une concentration de 10¹⁹ atomes par cm³.

Puis, une fois la deuxième zone dopée 4, on élimine le deuxième masque de résine 8 (figure 5E).

L'inconvénient majeur du procédé connu de la publication [2] décrit en référence aux figures 5A à 5E, est lié à la précision intrinsèque d'alignement d'un masque de résine par photolithographie classique par rapport à un élément en dessous : cette précision d'alignement est environ égale à ± 100 nm.

Ainsi, en appliquant les étapes du procédé connu, les largeurs unitaires L₂₃ et L₂₄ de la dalle 21 aux figures 3 et 4, qui définissent l'espacement de chaque zone dopée 3, 4 par rapport à l'arête 20 sont égales à 200 nm ± 100 nm.

Or, des précisions relativement mauvaises, i.e. de l'ordre de ± 100 nm sur les espacements L23 et L24, peuvent avoir des conséquences néfastes, notamment :
- des performances affectées du composant électronique mettant en oeuvre la jonction PIN,
- des performances non reproductibles d'un composant à un autre sur un même substrat en silicium SOI,
- des performances non reproductibles d'un substrat en silicium SOI à un autre substrat SOI.

De telles précisions d'espacement relativement mauvaises (± 100 nm) peuvent par exemple aussi affecter les performances d'un photo-détecteur guidé en germanium sur silicium, constitué d'une jonction PIN en germanium, comme décrit dans la publication [3]. On a reproduit à la figure 2 un tel photo-détecteur 5 en germanium. Il est constitué d'une zone intrinsèque 50 encadrée de part et d'autre par une zone 51 en germanium dopée par un dopant de type N et une zone 52 en germanium dopée par un dopant de type P. Chacune de ces zones dopées 51, 52 est recouverte respectivement d'une électrode 53, 54. Le photo-détecteur en germanium 5 est agencé en bout d'un guide d'onde optique droit 1' en silicium afin de convertir en signal électrique le signal optique guidé.

Ainsi, quel que soit le composant électronique (modulateur électro-optique en silicium, photo-détecteur en germanium ou autre) mettant en oeuvre une jonction PIN formée dans un guide en arête, il est donc primordial de disposer d'un procédé permettant de diminuer les imprécisions de positionnement entre les zones dopées P et N et la zone intrinsèque afin d'augmenter les performances, et de garantir leur reproductibilité.

Pour ce faire, il pourrait être envisagé pour chaque étape du procédé d'utiliser des techniques plus longues et/ou plus coûteuses que la technique de photolithographie classique, telles que la technique par lithographie par faisceau d'électrons.

Il existe donc un besoin pour diminuer les imprécisions de positionnement des zones dopées de type P et N par rapport à la zone intrinsèque d'une jonction PIN formée dans un guide en arête, sans avoir recours à des techniques plus longues et/ou coûteuses que la technique de photolithographie classique. Le but de l'invention est de répondre au moins à partie à ce(s) besoin(s).

### Exposé de l'invention

Pour ce faire, l'invention a tout d'abord pour objet selon une première alternative, un procédé de fabrication d'une jonction PIN en arête en matériau semi-conducteur, comportant les étapes successives suivantes:
a/ formation d'un premier masque dur constitué d'une première et deuxième bandes espacées l'une de l'autre, sur une couche en matériau semi-conducteur, la distance séparant les deux bandes définissant la largeur de l'arête tandis que la largeur unitaire de la première bande définit l'écartement entre l'arête et une zone dopée de type P et la largeur unitaire de la deuxième bande définit l'écartement entre l'arête et une zone dopée de type N;
b/ implantation d'un dopant respectivement de type P et de type N respectivement dans une zone et dans une zone à l'extérieur respectivement de la première bande et de la deuxième bande ;
c/ gravure partielle du matériau semi-conducteur dans les zones dopées et des zones de la couche en matériau semi-conducteur à l'extérieur de l'espace séparant les deux bandes de masque dur ;
d/ gravure partielle de la couche en matériau semi-conducteur à l'intérieur de l'espace séparant les deux bandes pour définir la hauteur de l'arête de la jonction PIN;
e/ dépôt pleine plaque d'une couche en matériau dur ;
f/ polissage mécano-chimique (CMP) pleine plaque jusqu'à atteindre les première et deuxième bandes de la couche en matériau semi-conducteur en saillie de part et d'autre de l'arête de sorte à éliminer le premier masque dur et former un deuxième masque dur recouvrant l'arête, les zones dopées gravées selon l'étape c/ et les zones de la couche en matériau semi-conducteur à l'extérieur de l'espace gravées selon l'étape c/ ;
g/ gravure partielle des première et deuxième bandes de la couche en matériau semi-conducteur, laissées libres par le deuxième masque dur de sorte à définir une dalle de part et d'autre de l'arête et jointe avec les zones dopées P et N, gravées formant ainsi la jonction PIN en arête;
h/ élimination du deuxième masque dur;
   procédé selon lequel la formation des masques dur et des masques de résine au cours des étapes a/ à d/ est réalisée par photolithographie.

Par « masque dur », on entend ici et dans le cadre de l'invention, un masque en un matériau minéral qui ne s'élimine pas lors de l'élimination de résines de masquage utilisées dans la technique de photolithographie classique.

Par « dépôt pleine plaque », on entend ici et dans le cadre de l'invention, le sens usuel de la technologie, aussi appelée « full wafer » en anglais, c'est-à-dire un dépôt d'une couche sur le dessus et qui recouvre toute la surface d'un substrat.

Par « remontées », on entend ici et dans le cadre de l'invention des protubérances par rapport aux zones de matériau semi-conducteur, qui sont de hauteur inférieure du fait que ces zones résultent de gravure.

L'invention permet donc d'obtenir des précisions de positionnement des zones dopées P et N, par rapport aux bords de l'arête, meilleures que 20nm en utilisant que la technique de photolithographie usuelle.

Autrement dit, l'invention consiste en un choix judicieux de définition de masques durs et d'enchaînement de formation des masques de résine pour l'implantation (dopage) et la gravure qui permet d'utiliser la technique de photo-lithographie usuelle malgré sa faible précision d'alignement (± 100nm) des masques par rapport aux zones situées en dessous.

Autrement dit encore, on réalise ce niveau de précisions de positionnement, ±20nm, avantageusement ± 5nm, sans avoir recours à d'autres techniques qui nécessitent un temps plus long et/ou qui sont de réalisation plus coûteuse, telles qu'une technique de lithographie par faisceau d'électrons (« e-beam lithography » en anglais).

Grâce au procédé selon l'invention, on obtient, à moindre coût et en un temps de réalisation plus faible par rapport à l'état de l'art, la formation d'une jonction PIN en arête, avec des zones dopées précisément espacées du bord de l'arête.

Ainsi, la jonction PIN obtenue selon le procédé de l'invention qui permet:
- d'atteindre des bonnes performances pour le composant qui met en oeuvre la jonction dans un guide, tel qu'un modulateur,
- de reproduire de manière fiable les performances d'un composant, sur un même substrat;
- de reproduire de manière fiable les performances de ce composant, d'un substrat à un autre substrat.

Selon un mode de réalisation avantageux, les étapes b/ à d/ consistent successivement en
- formation d'un premier masque de résine sur le premier masque dur et sur la couche en matériau semi-conducteur, telle que le premier masque de résine recouvre l'espace délimité entre les deux bandes de masque dur, et se superpose sur l'une des bandes en laissant dégagée une première zone de couche définissant la première zone d'implantation;
- implantation d'un dopant de type N dans la première zone d'implantation ;
- élimination du premier masque de résine;
- formation d'un deuxième masque de résine sur le premier masque dur et sur la couche en matériau semi-conducteur, telle que le deuxième masque de résine recouvre l'espace délimité entre les deux bandes et est se superpose sur 'autre bande en laissant dégagée une deuxième zone de couche mince définissant une deuxième zone d'implantation ;
- implantation d'un dopant de type P dans la deuxième zone d'implantation ;
- élimination du deuxième masque de résine.
- formation d'un troisième masque de résine au-dessus du premier masque dur et sur la couche en matériau semi-conducteur , telle que le troisième masque de résine recouvre l'espace délimité entre les deux bandes en étant en retrait par rapport aux bord externes des deux bandes, et en laissant dégagées au moins une partie des deux zones dopées P et N et les zones la couche en matériau semi-conducteur à l'extérieur des zones dopée, ,
- gravure de la couche à travers le troisième masque de résine et le premier masque dur;
- élimination du troisième masque de résine;
- formation d'un quatrième masque de résine sur le premier masque dur et sur la couche en matériau semi-conducteur, telle que le quatrième masque de résine est se superpose sur les bandes du premier masque dur, sur les zones extérieures et sur les zones dopées gravées, tout en laissant dégagé l'espace délimité entre elles ;
- gravure de la couche mince à travers le quatrième masque de résine et le premier masque dur jusqu'à obtenir la hauteur d'arête entre les deux bandes du premier masque dur;
- élimination du quatrième masque de résine

Selon une première variante avantageuse de formation du troisième masque de résine, celui-ci recouvre seulement l'espace délimité entre les deux bandes et en laissant ainsi dégagée la totalité des deux zones dopées P et.

Selon une deuxième variante avantageuse de formation du troisième masque de résine, celui-ci recouvre à la fois l'espace délimité entre les deux bandes, au moins une partie externe des deux zones dopées P et N une partie des zones externes de la couche de matériau semi-conducteur adjacente à chaque partie externe, de manière à ce qu'une fois réalisée lors de l'étape de gravure successive, les parties externes définissent des remontées des zones dopées P et N de hauteur égale à celle de l'arête;
le procédé comportant, après l'étape f/ de polissage CMP,
- une étape de formation d'un cinquième masque de résine recouvrant les remontées des zones dopées P et N, les remontées et de la couche adjacentes aux remontées des zones dopées qui ne sont pas recouvertes par le deuxième masque dur, et se superpose aux zones dopées gravées et aux zones extérieures gravées de la couche;
- une étape d'élimination du cinquième masque de résine avant l'étape h/ d'élimination du deuxième masque dur.

Cette deuxième variante est avantageuse car elle permet des remontées des zones dopées P et N également avec une très grande précision d'alignement par rapport aux bords de l'arête, ce qui diminue fortement et de manière précise les résistances d'accès à la jonction PIN. Ainsi, les composants électroniques mettant en oeuvre une telle jonction PIN avec remontées ont leurs performances encore améliorées. En particulier, un modulateur électro-optique avec la jonction PIN à remontées présente une plus faible résistance d'accès. Un photo-détecteur avec la jonction PIN à remontées présente également une plus faible résistance d'accès.

De préférence, le matériau dur déposé lors de l'étape e/ est le même que celui formant le premier masque dur. On utilise ainsi le même matériau, avantageusement la silice pour le dépôt pleine plaque et la réalisation des masques durs.

De préférence encore, le premier et/ou deuxième masque(s) dur(s) est (sont) réalisé(s) en un matériau dur choisi parmi la silice, et le nitrure de silicium.

Selon une première variante de réalisation de la couche en matériau semi-conducteur, celle-ci est une couche mince de silicium.

Selon une deuxième variante de réalisation de la couche en matériau semi-conducteur, celle-ci est en un matériau semi-conducteur différent du silicium et est formée sur une couche mince de silicium. Selon cette deuxième variante, la couche en matériau semi-conducteur est avantageusement une couche mince de germanium.

De préférence, la jonction en arête obtenue par le procédé selon l'invention est formée dans un guide d'onde.

L'invention concerne également sous un autre de ses aspects, un modulateur électro-optique latéral formé dans la couche de silicium préférentiellement d'un substrat SOI ou photo-détecteur formé dans une couche mince de germanium formée sur la couche mince de silicium préférentiellement d'un substrat SOI, obtenu selon le procédé qui vient d'être décrit. Le fonctionnement d'un modulateur électro-optique mettant en oeuvre la jonction PIN dans un guide en arête selon l'invention est par injection de porteurs.

L'invention concerne enfin un modulateur électro-optique en silicium ou un photo-détecteur en germanium, obtenu selon le procédé de l'invention, caractérisé en ce que la hauteur de la dalle, mesurée en coupe transversale, est différente de la hauteur des parties des zones dopées adjacentes. On peut effectuer un contrôle de cette différence de hauteur, typiquement à ± 5 nm, voire à ± 10 nm, au moyen d'un faisceau ionique focalisé, également connue sous l'acronyme anglais FIB pour « Focused ion beam. ».

### Description détaillée

D'autres avantages et caractéristiques de l'invention ressortiront mieux à la lecture de la description détaillée de l'invention faite à titre illustratif et non limitatif en référence aux figures suivantes parmi lesquelles :
- la figure 1, est une vue de dessus d'un modulateur électro-optique en silicium intégré sur un substrat SOI selon l'état de l'art ;
- la figure 1A est une vue en coupe transversale du guide d'onde optique en arête à jonction PIN du modulateur selon la figure 1 ;
- la figure 2 est une vue en perspective d'un photo-détecteur en germanium intégré sur un substrat SOI selon l'état de l'art;
- la figure 3 est une vue en coupe transversale du guide d'onde optique en arête à jonction PIN, selon la figure 1A indiquant les dimensions relatives obtenues selon un procédé de fabrication selon l'état de l'art ;
- la figure 4 illustre une variante avantageuse de la figure 3 selon l'état de l'art, montrant une remontée d'une partie des zones dopées de type P et de type N;
- les figures 5A à 5E sont des vues en coupe transversale illustrant les différentes étapes de réalisation d'un procédé de fabrication d'une jonction PIN en arête selon la figure 3;
- les figures 6A à 6K sont des vues en coupe transversale illustrant les différentes étapes d'un premier mode de réalisation du procédé de fabrication d'un guide d'onde en arête à jonction PIN selon l'invention d'un modulateur électro-optique;
- les figures 7A à 7L sont des vues en coupe transversale illustrant les différentes étapes d'un deuxième mode de réalisation du procédé de fabrication d'un guide d'onde en arête à jonction PIN selon l'invention d'un modulateur électro-optique;
- la figure 8 est un vue en coupe transversale d'un photo-détecteur en germanium obtenu selon le procédé de l'invention, formé sur une couche de germanium au-dessus d'une couche de silicium ;
- la figure 9 est une vue en perspective du photo-détecteur en germanium selon la figure 8.

Les figures 1 à 5E relatives à l'état de l'art ont déjà été commentées en préambule. Elles ne sont donc pas détaillées ci-après.

Par souci de clarté, les mêmes éléments d'une jonction PIN en arête selon l'état de l'art et d'une jonction PIN en arête selon l'invention sont désignés par les mêmes références numériques.

On précise également qu'ici et dans l'ensemble de la présente demande, les termes « inférieur », « supérieur », « intérieur », « extérieur », « « interne » « externe» sont à comprendre par référence à une jonction PIN en arête selon l'invention en vue de coupe transversale, i.e. orthogonale au plan du substrat sur laquelle elle est réalisée, avec l'arête à la verticale et au-dessus de la couche mince en matériau semi-conducteur.

Les expressions « extérieur » et « intérieur » sont également à comprendre par référence à une jonction PIN en arête selon l'invention en vue de coupe transversale.

Les expressions « hauteur » et « épaisseur » sont à comprendre comme étant synonymes.

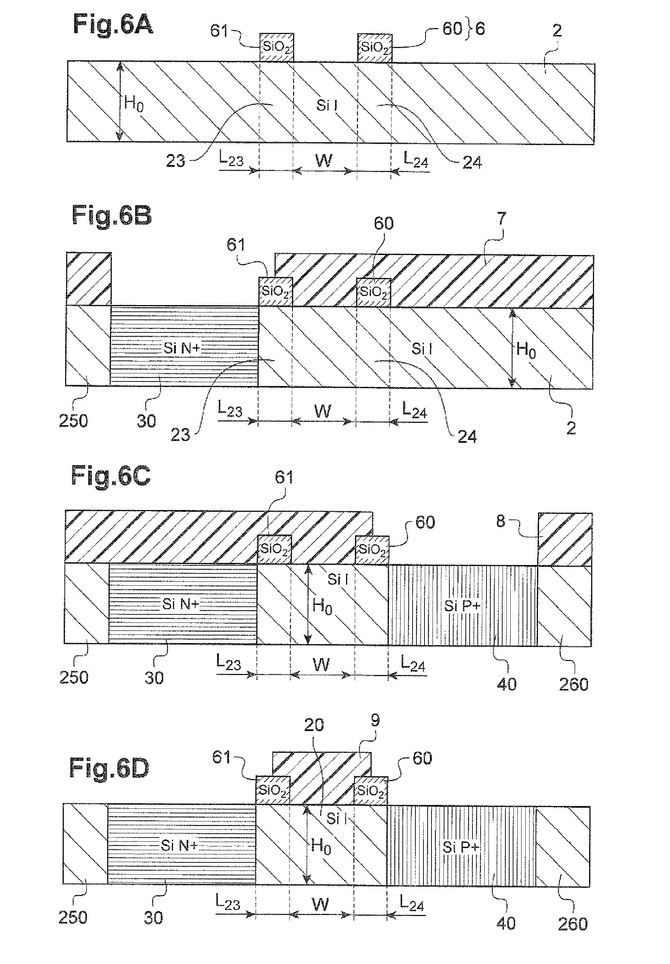

On précise également que sur l'ensemble des figures 6A à 12, on a indiqué le symbole du matériau constituant une zone donnée.

Ainsi, avec une couche en silicium :
- Si I signifie silicium intrinsèque, c'est-à-dire non intentionnellement dopé ;
- Si P+, Si N+ signifient respectivement silicium dopé au dopant P+, silicium dopé au dopant N+ ;

Avec une couche en germanium:
- Ge I signifie germanium intrinsèque, c'est-à-dire non intentionnellement dopé;
- Ge P+, Ge N+ signifient respectivement germanium dopé au dopant P+, germanium dopé au dopant N+.

On précise également qu'on n'a pas représenté la couche de matériau diélectrique déposée au final sur l'arête 20 et sur les zones 3, 4 dopées de la jonction PIN obtenue selon le procédé de l'invention.

On précise enfin qu'on ne décrit pas en détail la réalisation de la couche de silice SiO2 qui enterre la jonction PIN en arête selon l'invention, ni la réalisation des contacts métalliques pour la constitution des électrodes en contact électrique avec les zones dopées. On pourra dans le cadre de l'invention mettre en oeuvre les étapes de finition telles que décrites dans la publication [2], à savoir une étape de dépôt de couche de silice d'une épaisseur d'environ 1µm suivie d'une étape de recuit permettant l'activation des dopants, par exemple 15 secondes à 1050°C pour le dopant P+ et 13 minutes à 900°C pour celui N+, puis une étape d'ouverture de trous (vias) dans la silice et remplissage de métal afin de constituer les contacts électriques des électrodes.

Conformément à l'invention, une jonction PIN en arête formant un guide d'onde d'un modulateur électro-optique est obtenue par un procédé de fabrication dont les étapes sont réalisées uniquement par photolithographie classique.

On décrit en référence aux figures 6A à 6K, les étapes successives du procédé de fabrication selon un premier mode de réalisation de l'invention.

La jonction PIN 1 est réalisée à partir d'une couche 2 d'un matériau semi-conducteur, initialement non intentionnellement dopée. Cette couche peut être une couche de silicium d'un substrat SOI recouvrant une couche d'oxyde enterrée.

Sur la couche 2 d'épaisseur initiale H₀, on forme par photolithographie un premier masque dur 6 constitué de deux bandes 60, 61 d'une largeur unitaire L23, L24 et espacées l'une de l'autre d'une distance W (figure 6A).

A la fin du procédé de fabrication, W définit la largeur de l'arête 20 et les largeurs unitaires respectivement L₂₃, L₂₄ définissent les écartements entre les bords de l'arête 20 et respectivement la zone 3 dopée N+ et la zone 4 dopée P+. Ces largeurs unitaires L₂₃, L₂₄ définissent ainsi les largeurs de la dalle 21 du matériau semi-conducteur non intentionnellement dopé de la couche 2 qui sera obtenue de part et d'autre de l'arête 20 à la fin du procédé. Autrement dit, les bandes 60, 61 de masque dur se superposent chacune respectivement sur des bandes 24, 23 de couche 2 de matériau semi-conducteur non intentionnellement dopé de largeur unitaire respective L24, L23. Ces largeurs unitaires L₂₃, L₂₄ peuvent être égales entre elles. Comme il ressort par la suite, le dimensionnement de ces largeurs unitaires L₂₃, L₂₄ des bandes 60, 61 de masque dur est judicieusement sélectionné pour avoir d'une part un espacement déterminé entre les bords de l'arête 20 et chacune des zones dopées 3, 4, et d'autre part pour prendre en compte les imprécisions d'alignement de la technique de photolithographie usuelle, égales à ± 100nm. Le fait de dimensionner les largeurs L23 et L24 des bandes 60, 61 de masque dur de sorte à ce qu'elles soient supérieures aux imprécisions d'alignement permet à coup sûr d'avoir une superposition des masques de résine sur les parties des masques durs mis en oeuvre lors du procédé. Typiquement, avec les tolérances usuelles de photolithographie sur les dimensions du masque 6, i.e. égales à ± 5nm, on obtient une distance W entre les deux bandes 60, 61 égale à 450 ± 5 nm, une largeur unitaire L₂₃, L₂₄ de chaque bande 60, 61 égale à 200 ± 5nm.

Le premier masque dur est formé par gravure d'une couche de matériau dur. Tel qu'illustré, le premier masque dur 6 constitué des bandes 60, 61, est en silice. Il peut également être en nitrure de silicium ou en toute autre matière minérale qui ne s'élimine pas lors d'élimination de résines utilisées dans des techniques usuelles de photolithographie.

Puis, on forme par photolithographie un premier masque de résine 7 sur les bandes 60, 61 du premier masque dur 6 et sur la couche 2. Ce premier masque de résine 7 recouvre ainsi l'espace 20 délimité entre les deux bandes 60, 61 et se superpose à la bande 61, c'est-à-dire recouvre au moins en partie la bande 61, en laissant dégagée une première zone 30 de couche définissant une première zone d'implantation (figure 6B). Comme précisé ci-dessus, la largeur unitaire L₂₃ de la bande 61 du masque dur 6 est dimensionnée pour être supérieure aux imprécisions d'alignement du masque de résine 7 par photolithographie, égales à ± 100 nm. De ce fait, on obtient la superposition du masque de résine 7 sur la bande 61 de masque dur 6 de manière systématique, malgré les imprécisions d'alignement typiques de la photolithographie.

Autrement dit, la première zone d'implantation 30 est définie entre la bande de masque dur 61 et une zone 250 de couche 2 située à l'extérieur, c'est-à-dire latéralement à l'opposé de la bande de masque dur, cette zone 250 étant recouverte par le premier masque de résine 7 (figure 6B).

On implante alors un dopant de type N+ dans la première zone d'implantation 30 (figure 6B). On précise ici que l'implantation, que ce soit du dopant de type N ou de type P, peut se faire aussi bien par implantation ionique que par plasma. Lorsqu'on souhaite réaliser une jonction PIN selon l'invention mise en oeuvre dans un photo-détecteur, on utilise de préférence une implantation ionique. Le dopant de type N+ peut être du phosphore à une concentration de 10¹⁹ atomes par cm³.

Puis, une fois la première zone 30 dopée, on élimine le premier masque de résine 7.

On forme ensuite un deuxième masque de résine 8 sur les bandes 60, 61 du premier masque dur 6 et sur la couche mince 2. Ainsi, ce deuxième masque de résine 8 recouvre l'espace 20 délimité entre les deux bandes 60, 61 et se superpose à la bande 60, c'est-à-dire recouvre au moins en partie la bande 60, en laissant dégagée une deuxième zone 40 de couche définissant une deuxième zone d'implantation (figure 6C). Tout comme précédemment, la largeur unitaire L24 de la bande 60 du masque dur 6 est dimensionnée pour être supérieure aux imprécisions d'alignement du masque de résine 8 par photolithographie, égales à ± 100 nm. On obtient donc ici encore la superposition du masque de résine 8 sur la bande 60 de masque dur 6 de manière systématique, malgré les imprécisions d'alignement typiques de la photolithographie.

Autrement dit, la deuxième zone d'implantation 40 est définie entre la bande de masque dur 60 et une zone 260 de couche 2 située à l'extérieur, c'est-à-dire latéralement à l'opposé de la bande de masque dur, cette zone 260 recouverte par le deuxième masque de résine 8 (figure 6C).

On implante alors un dopant de type P dans la deuxième zone d'implantation 40 (figure 6C). Le dopant de type P+ peut être du bore à une concentration de 10¹⁹ atomes par cm³.

Puis, une fois la deuxième zone dopée 40, on élimine le deuxième masque de résine 8.

On forme ensuite un troisième masque de résine 9 au-dessus des bandes 60, 61 du premier masque dur 6et sur l'espace 20 de la couche 2 délimité entre les deux bandes 60 et 61. Ce troisième masque de résine 9 recouvre donc l'espace 20 délimité entre les deux bandes et en laissant ainsi dégagées la totalité 30, 40 des deux zones dopées P et N et des zones 250, 260 de couche 2 à l'extérieur (figure 6D).

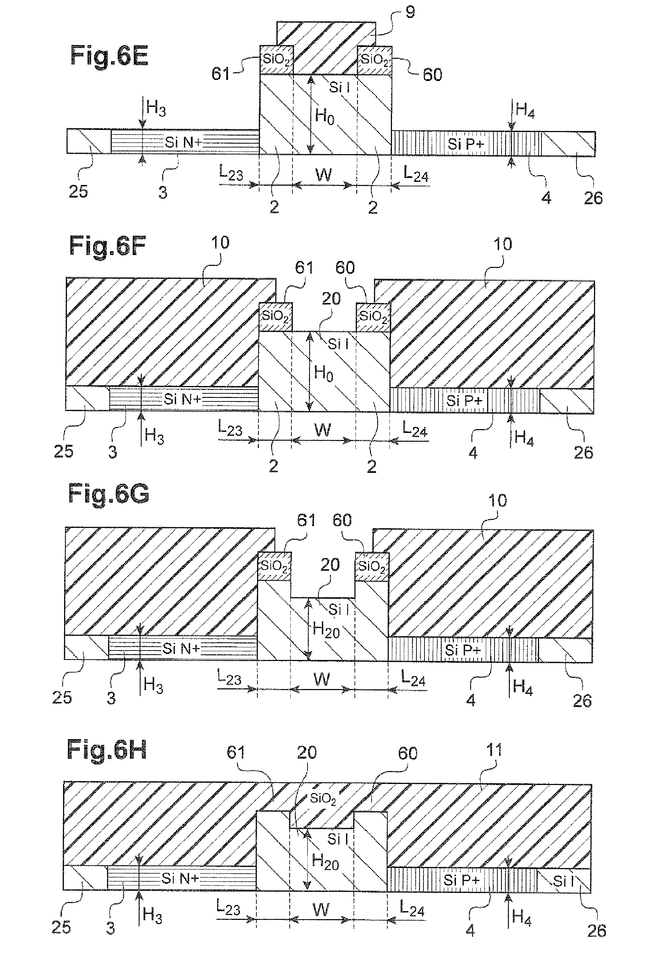

On réalise alors la gravure partielle du matériau de la couche 2 non recouverte par le masque de résine 9 et par les bandes 60, 61 de masque dur pour laisser une épaisseur de matériau, de préférence sensiblement constante pour toutes les zones non recouvertes. Ainsi, les zones dopées 3 et 4 gravées ainsi que les zones du matériau semi-conducteur intrinsèque extérieures 25, 26 gravées sont d'épaisseur égale entre elles (figure 6 E).

On élimine le troisième masque de résine 9.

Puis, on forme un quatrième masque de résine 10 qui vient se superposer sur chaque bande 60, 61 du premier masque dur 6sur les zones extérieures gravées 25, 26 et sur les zones dopées 3, 4 gravées, tout en laissant dégagé l'espace 20 délimitée entre bandes 60, 61 du masque dur 6 (figure 6F). Comme déjà expliqué, les largeurs unitaires L₂₃, L₂₄ des bandes 60 et 61 du masque dur 6 ont été dimensionnées pour être supérieures aux imprécisions d'alignement du masque de résine 10 par photolithographie, égales à ± 100 nm. On obtient donc ici encore la superposition, c'est-à-dire le recouvrement au moins partiel, du masque de résine 10 sur chacune des bandes 60, 61 de masque dur 6 de manière systématique, malgré les imprécisions d'alignement typiques de la photolithographie.

On effectue alors la gravure du matériau semi-conducteur à travers le quatrième masque de résine 10 et le premier masque dur 6, c'est-à-dire dans l'espace 20 délimité par les bandes 60, 61 de ce dernier jusqu'à obtenir la hauteur H₂₀ d'arête 20 entre les deux bandes 60, 61 (figure 6G). On élimine alors le quatrième masque de résine 10.

On réalise alors un dépôt pleine plaque d'une couche 11 de matériau de même nature que le masque dur 6 : ainsi le premier masque dur 6 devient enterré par la couche pleine plaque 11 (figure 6H).

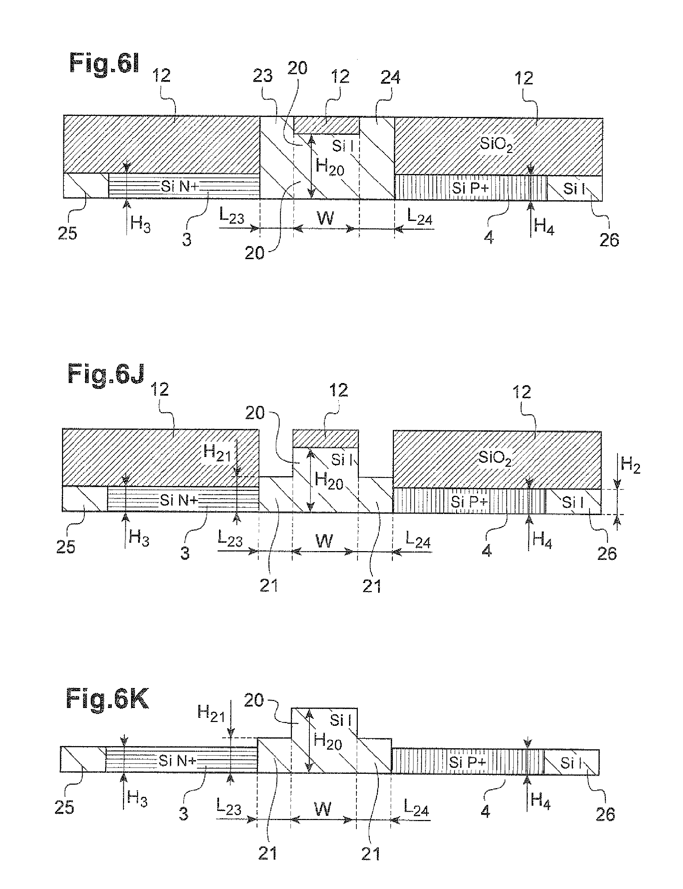

Puis, on effectue un polissage mécano-chimique (CMP) pleine plaque jusqu'à atteindre les première 23 et deuxième 24 bandes de la couche 2 de matériau semi-conducteur encore non gravée, et en saillie de part et d'autre de l'arête 20 (figure 6I). On précise à nouveau que ces première 23 et deuxième 24 bandes sont celles sous-jacentes respectivement aux bandes 61, 60 du premier masque dur 6. Le premier masque dur 6, a ainsi disparu, et un deuxième masque dur 12 recouvrant l'arête 20, les zones dopées 3, 4, et les zones extérieures 25 et 26 de la couche 2 de part et d'autre des zones dopées 3 et 4.

On effectue alors la gravure partielle du matériau semi-conducteur 2 à travers le deuxième masque dur 12 de sorte à définir une dalle 21 de part et d'autre de l'arête 20, jointe aux zones 3, 4 dopées P et N formant ainsi la jonction PIN en arête 20, 21 (figure 6J).

On élimine enfin le deuxième masque dur 12 (figure 6K). Comme il ressort de la figure 6K, le procédé de réalisation de la jonction PIN en arête se caractérise également par le fait que l'on obtient une hauteur H₂₁ de la dalle 21 qui est différente de la hauteur H3 = H4 des parties des zones dopées 3, 4 adjacentes et des zones externes 25, 26 de la couche de matériau semi-conducteur intrinsèque 2 de part et d'autre de ces zones 3, 4. Dans l'exemple illustré de la figure 6K, la hauteur H₂₁ de la dalle 21 est supérieure de la hauteur H3 = H4 des parties des zones dopées 3, 4 adjacentes. On peut effectuer un contrôle de cette différence de hauteur H₂₁-H₃, typiquement à ± 5 nm, voire à ± 10 nm, au moyen d'un- faisceau ionique focalisé, également connue sous l'acronyme anglais FIB pour « Focused ion beam. »

Grâce au procédé selon le premier mode de réalisation de l'invention, on obtient une jonction PIN en arête dont les zones dopées 3, 4 sont séparées de l'arête par la dalle 21 en matériau semi-conducteur intrinsèque et ainsi positionnées par rapport aux bords de l'arête 20 avec une tolérance meilleure que 5 nm. Cette précision de 5nm correspond exactement à la précision de réalisation de la bande 60 ou de la bande 61 du masque dur 6. Ce positionnement précis est obtenu avantageusement uniquement par une technique de photolithographie.

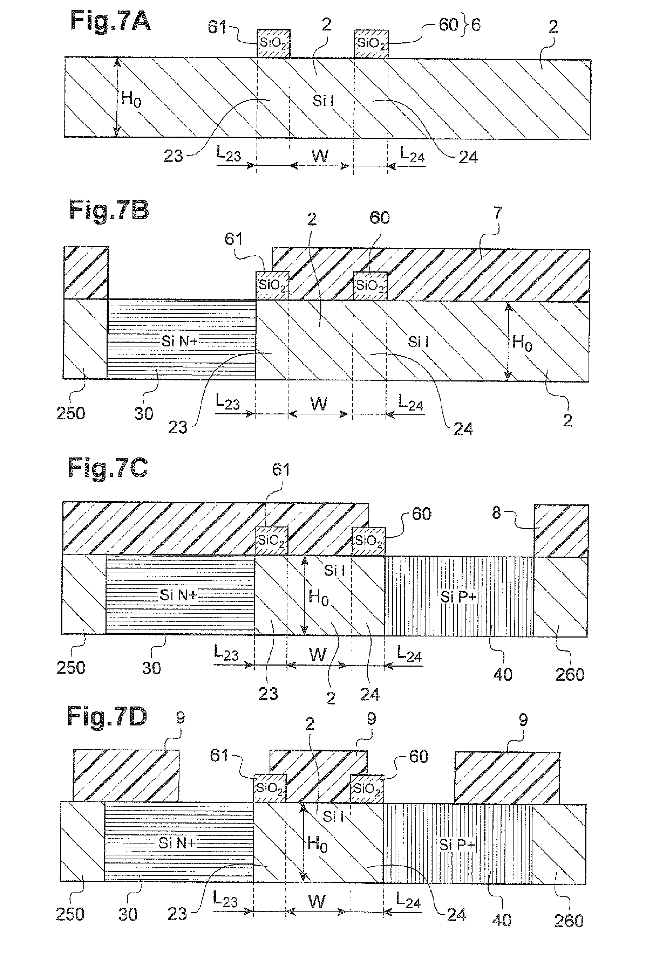

On décrit maintenant en référence aux figures 7A à 7L, les étapes successives du procédé de fabrication selon un deuxième mode de réalisation de l'invention.

Les étapes selon les figures 7A à 7C sont strictement identiques aux figures 6A à 6C qui viennent d'être décrites. Elles ne sont donc pas commentées ici.

Une fois les zones dopées 30, 40 obtenues et le deuxième masque de résine 8 éliminé, on forme un troisième masque de résine 9. Ce troisième masque de résine recouvre, selon ce deuxième mode, à la fois l'espace 20 délimité entre les deux bandes 60, 61, au moins une partie externe 30, 40 des deux zones dopées P et N et une partie des zones externes 250, 260 de la couche de matériau semi-conducteur intrinsèque 2 adjacente à chaque partie externe 30, 40 (figure 7D). De cette manière, une fois réalisée lors de l'étape de gravure successive, les parties externes 30, 40 dopées définissent des remontées 30, 40 des zones dopées P et N de hauteur H₃₀, H₄₀ égale à celle H₂₀ de l'arête 20.

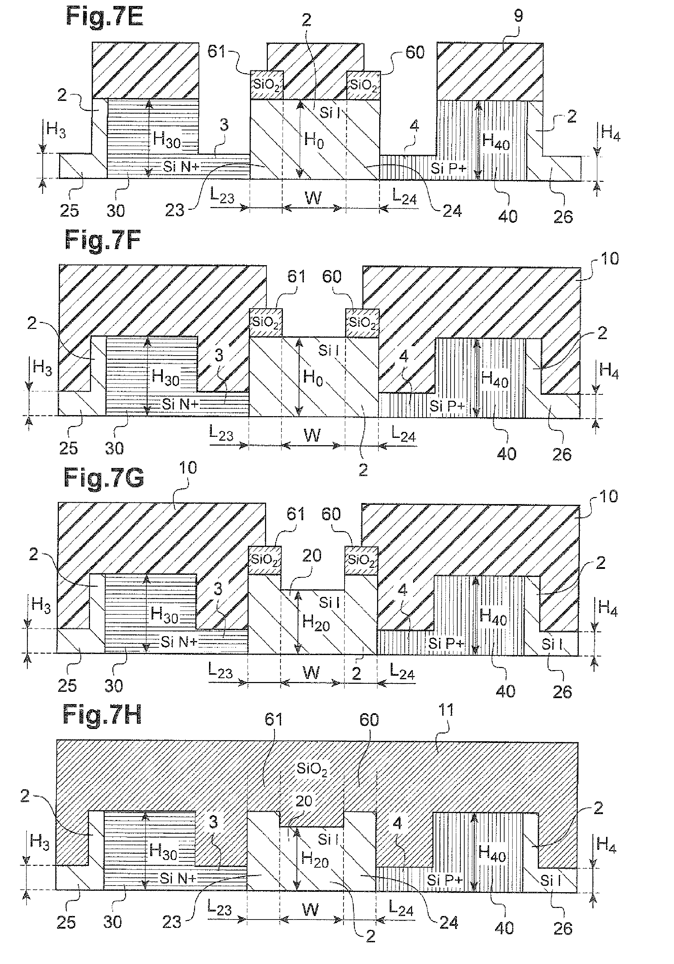

L'étape de gravure partielle illustrée à la figure 7E est réalisée de manière identique à celle de la figure 6E. La hauteur initiale H0 de la couche de silicium 20 devient alors égale pour les zones dopées 3, 4 de part et d'autre de l'arête 20 et pour le matériau semi-conducteur intrinsèque 2 à l'extérieur de ces zones 3, 4 : H₃ = H₄= H₂. On élimine le troisième masque de résine 9. Par contre, la hauteur H₃₀= H₄₀ des parties externes 30, 40 masquées par le troisième masque est égale à la hauteur H₂₀ de l'arête 20 également masquée par le masque 9.

Puis, on forme un quatrième masque de résine 10 qui vient se superposer sur le chaque bande 60, 61 du premier masque dur 6, sur les zones extérieures gravées 25, 26 et sur et sur les zones dopées gravées 3,4 ou non 30, 40, tout en laissant dégagé l'espace 20 délimitée entre bandes 60, 61 du masque dur 6 (figure 7F). Comme déjà expliqué pour le premier mode de réalisation, les largeurs unitaires L₂₃, L₂₄ des bandes 60, 61 du masque dur 6 ont été dimensionnées pour être supérieures aux imprécisions d'alignement du masque de résine 10 par photolithographie, égales à ± 100 nm. On obtient donc ici encore la superposition du masque de résine 10 sur chacune des bandes 60, 61 de masque dur 6 de manière systématique, malgré les imprécisions d'alignement typiques de la photolithographie.

On effectue alors la gravure partielle du matériau semi-conducteur 2 à travers le quatrième masque de résine 10 et le premier masque dur 6, c'est-à-dire dans l'espace 20 délimité par les bandes 60, 61 de ce dernier jusqu'à obtenir la hauteur H₂₀ d'arête 20 entre les deux bandes 60, 61 (figure 7G). On élimine alors le quatrième masque de résine 10.

On réalise alors un dépôt pleine plaque d'une couche 11 de matériau de même nature que le masque dur 6: ainsi le premier masque dur 6 devient enterré par la couche pleine plaque 11 (figure 7H).

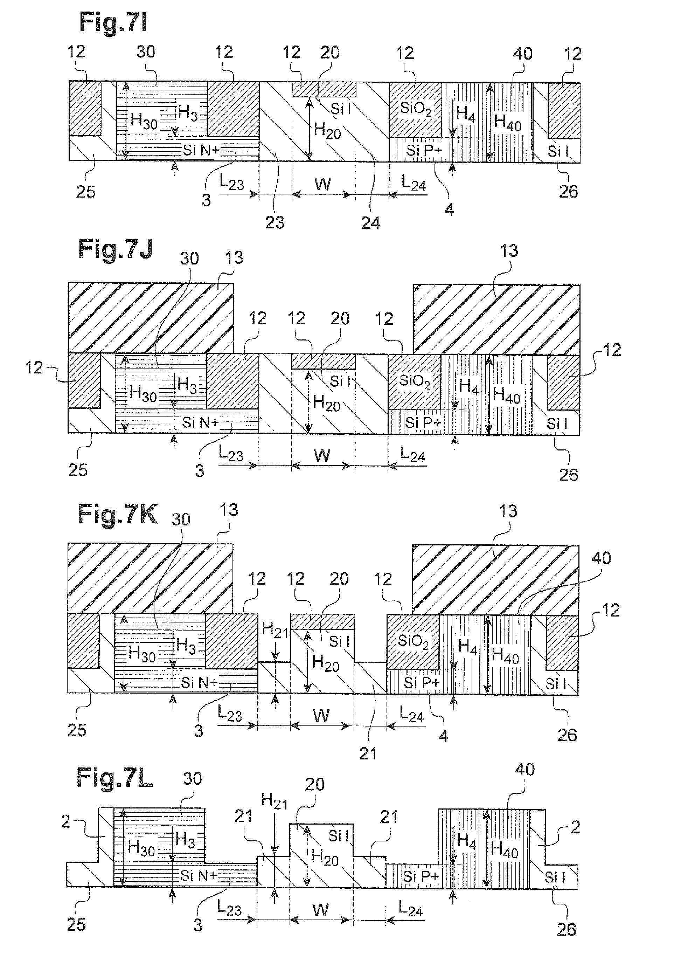

Puis, on effectue un polissage mécano-chimique (CMP) pleine plaque jusqu'à atteindre les première 23 et deuxième 24 bandes de la couche 2 de matériau semi-conducteur intrinsèque en saillie de part et d'autre de l'arête 20 et, les remontées 30, 40 des zones dopées 3, 4 (figure 7I). Ces première 23 et deuxième 24 bandes sont celles sous-jacentes respectivement aux première 60 et deuxième 61 bandes de masque dur. Le premier masque dur 6 a ainsi disparu et un deuxième masque dur 12 recouvrant l'arête 20, les zones dopées 3, 4 à l'exclusion des protubérances 30, 40 formant les remontées et les zones extérieures 25 et 26 de la couche 2 de part et d'autre des zones dopées 3 et 4.

On forme ensuite un cinquième masque de résine 13 recouvrant les remontées 30, 40 des zones dopées P et N, les remontées de la couche 2 adjacentes aux remontées des zones dopées qui ne sont pas recouvertes par le deuxième masque dur 12 et se superpose aux zones dopées gravées 3, 4 et aux zones extérieures 25, 26 gravées de la couche 2(figure 7J). Ici encore, on obtient la superposition du masque de résine 13 sur les parties de masque dur 12 de manière systématique, malgré les imprécisions d'alignement typiques de la photolithographie, égales à ± 100 nm.

Puis, on grave alors partiellement la couche du matériau 2 à travers le deuxième masque dur 12 et le cinquième masque de résine 13 de sorte à définir une dalle 21 de part et d'autre de l'arête 20, jointe avec les zones 3, 4 dopées P et N formant ainsi la jonction PIN en arête 20, 21 (figure 7K).

On élimine enfin le cinquième masque de résine 13, avant d'éliminer le deuxième masque dur 12 (figure 7L).

Comme il ressort de la figure 7L, le procédé de réalisation de la jonction PIN en arête se caractérise également par le fait que l'on obtient une hauteur H₂₁ de la dalle 21 qui est différente de la hauteur H3, H4 des parties des zones dopées 3, 4 adjacentes et des zones externes 25, 26 de la couche intrinsèque 2 de part et d'autre de ces zones 3, 4. Dans l'exemple illustré de la figure 6K, la hauteur H21 de la dalle 21 est supérieure de la hauteur H3 = H4 des parties des zones dopées 3, 4 adjacentes. On peut effectuer un contrôle de cette différence de hauteur H₂₁-H₃, typiquement à ± 5 nm, voire à ± 10 nm, au moyen d'une sonde ionique focalisée, également connue sous l'acronyme anglais FIB pour « Focused ion beam. »

Grâce au procédé selon le deuxième mode de réalisation de l'invention, on obtient, tout comme dans le premier mode, une jonction PIN en arête 20 avec des zones dopées 3, 4 séparées de l'arête par la dalle 21 et ainsi positionnées par rapport aux bords de l'arête 20 avec une tolérance meilleure que 5 nm. Ce positionnement précis est obtenu avantageusement uniquement par une technique de photolithographie.

On obtient en outre une jonction PIN avec des remontées 30, 40 également positionnées par rapport aux bords de l'arête 20 avec une tolérance d'alignement meilleure que 5 nm. Une jonction PIN illustrée à la figure 7L présente en sus de celle illustrée à la figure 6K, de plus petits résistances d'accès lorsqu'elle est mise en oeuvre dans un modulateur électro-optique.

Une jonction PIN en arête 20 obtenue selon le premier ou le deuxième procédé qui viennent d'être décrits, lorsqu'elle forme un guide d'onde optique, présente de bonnes performances du fait des faibles incertitudes d'alignement susmentionnées, et donc peut être avantageusement mise en oeuvre dans un modulateur électro-optique en silicium.

Grâce aux procédés selon l'invention qui viennent d'être décrits, on peut également obtenir un photo-détecteur en germanium, la couche de matériau semi-conducteur 2 que l'on grave étant alors une couche de germanium. Cette couche de germanium est formée au-dessus de la couche de silicium préférentiellement du substrat SOI selon une technique de croissance par épitaxie dans une cavité de la couche de silicium, comme décrit dans la publication [3].

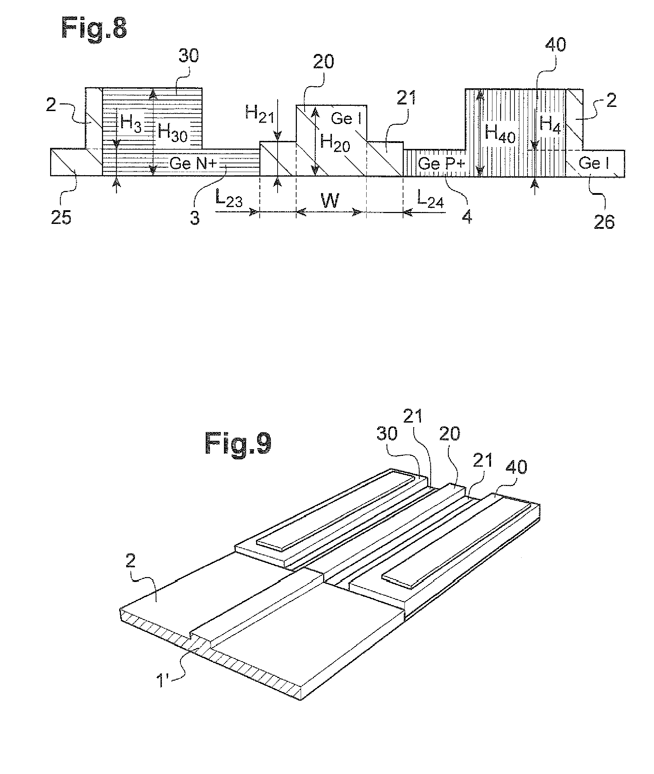

On a illustré en figures 8 et 9, un photo-détecteur selon l'invention, obtenu selon le deuxième procédé qui vient d'être décrit, i.e. avec des remontées 30, 40. Comme indiqué en préambule en référence à la figure 2, l'arête 20 et la dalle 21 de la jonction PIN d'un tel photo-détecteur doivent être alignées sur le guide d'onde droit 1' en silicium réalisé sur la couche de silicium 2 du substrat SOI. La réalisation du photo-détecteur en germanium selon l'invention, tel que celui montré en figures 8 et 9, peut d'ailleurs être avantageusement simultanée à la réalisation de l'arête du guide droit 1' en silicium, car les cinétiques de gravure du silicium et du germanium sont identiques. Autrement dit, pour un photo-détecteur selon l'invention, la gravure du guide d'onde en silicium peut se faire en même temps que le guide en germanium, car les cinétiques de gravure sont les mêmes.

On peut d'ailleurs noter que la hauteur de la dalle 21 de la jonction en arête 20 du photo-détecteur en germanium est différente à la dalle de la couche de silicium du guide d'onde droit. Ici encore, on peut effectuer un contrôle de cette différence de hauteur, typiquement à ± 5 nm, voire à ± 10 nm, au moyen d'un faisceau ionique focalisé, technique de contrôle dimensionnel également connue sous l'acronyme anglais FIB pour « Focused ion beam. »

L'invention n'est pas limitée aux exemples qui viennent d'être décrits ; on peut notamment combiner entre elles des caractéristiques des exemples illustrés au sein de variantes non illustrées.

### Références citées :

[1] : S. Manipatruni, Q. Xu, B. Schmidt, J. Shakya, and M. Lipson, "High speed carrier injection 18Gb/s silicon micro-ring electro-optic modulator," in IEEE LEOS Annual Meeting (2007), pp. 537-538 ;
[2] : Q. Xu, B. Schmidt, S. Pradhan, and M. Lipson, "Micrometre-scale silicon electro-optic modulator ", Nature, Vol. 435, pp. 325-327, 19 May 2005 ;
[3] : L. Vivien, "Zero-bias 40Gbit/s germanium waveguide photodetector on silicon", OPTICS EXPRESS, January 2012 / Vol. 20, No. 2, Jan. 2012.

## Revendications

1. Procédé de fabrication d'une jonction PIN en arête (20, 21) en matériau semi-conducteur, comportant les étapes successives suivantes:
a/ formation d'un premier masque dur (6) constitué d'une première (60) et deuxième (61) bandes espacées l'une de l'autre, sur une couche (2) en matériau semi-conducteur, la distance W séparant les deux bandes définissant la largeur de l'arête (20) tandis que la largeur unitaire (L₂₄) de la première bande (60) définit l'écartement entre l'arête et une zone (4) dopée de type P et la largeur unitaire (L₂₃) de la deuxième bande (61) définit l'écartement entre l'arête et une zone (3) dopée de type N; les largeurs unitaires de la première et deuxième bandes étant supérieures aux tolérances d'alignement de la photolithographie ;
b/ implantation d'un dopant respectivement de type P et de type N respectivement dans une zone (40) et dans une zone (30) à l'extérieur respectivement de la première bande (60) et de la deuxième (61) bande c/ gravure partielle du matériau semi-conducteur dans les zones dopées (30, 40) et des zones (250, 260) de la couche (2) en matériau semi-conducteur à l'extérieur de l'espace (20) séparant les deux bandes (60, 61) de masque dur
d/ gravure partielle de la couche en matériau semi-conducteur à l'intérieur de l'espace (20) séparant les deux bandes pour définir la hauteur (H₂₀) de l'arête (20) de la jonction PIN;
e/ dépôt pleine plaque d'une couche (11) en matériau dur ;
f/ polissage mécano-chimique (CMP) pleine plaque jusqu'à atteindre les première (23) et deuxième (24) bandes de la couche en matériau semi-conducteur en saillie de part et d'autre de l'arête (20) de sorte à éliminer le premier masque dur (6, 60, 61) et former un deuxième masque dur (12) recouvrant l'arête (20),, les zones dopées (3,4) gravées selon l'étape c/ et les zones (25, 26) de la couche (2) en matériau semi-conducteur à l'extérieur de l'espace (20) gravées selon l'étape c/ ;
g/ gravure partielle des première (23) et deuxième (24) bandes de la couche en matériau semi-conducteur, laissées libres par le deuxième masque dur (12) de sorte à définir une dalle (21) de part et d'autre de l'arête et jointe avec les zones (3, 4) dopées P et N, gravées formant ainsi la jonction PIN en arête (20, 21) ;
h/ élimination du deuxième masque dur (12);
procédé selon lequel la formation des masques dur (6, 60, 61 ; 12) et des masques de résine (7, 8, 9, 10, 13) au cours des étapes a/ à d/ est réalisée par photolithographie.

2. Procédé selon la revendication 1, selon lequel les étapes b/ à d/ consistent successivement en :
- formation d'un premier masque de résine (7) sur le premier masque dur (6, 60, 61) et sur la couche en matériau semi-conducteur (2), telle que le premier masque de résine (7)recouvre l'espace délimité (20) entre les deux bandes (60, 61) et se superpose sur l'une des bandes (61) en laissant dégagée une première zone (30) de couche définissant la première zone d'implantation ;
- implantation d'un dopant de type N dans la première zone d'implantation (3, 30);
- élimination du premier masque de résine (7) ;
- formation d'un deuxième masque de résine (8) sur le premier masque dur (6, 60, 61) et sur la couche en matériau semi-conducteur (2), telle que le deuxième masque de résine recouvre l'espace (20) délimité entre les deux bandes (60, 61) et se superpose sur l'autre bande (60) en laissant dégagée une deuxième zone (40) de couche définissant la deuxième zone d'implantation ;
- implantation d'un dopant de type P dans la deuxième zone d'implantation ;
- élimination du deuxième masque de résine (8) ;
- formation d'un troisième masque de résine (9) au-dessus du premier masque dur (6, 60, 61) et sur la couche en matériau semi-conducteur (2), telle que le troisième masque de résine recouvre l'espace (20) délimité entre les deux bandes, et en laissant dégagée au moins une partie des deux zones (30 ; 40) dopées P et les zones (250, 260) la couche en matériau semi-conducteur (2) à l'extérieur des zones dopée (30, 40),
- gravure partielle de la couche (250, 30, 40 ; 260) à travers le troisième masque de résine (9) et le premier masque dur;
- élimination du troisième masque de résine (9);
- formation d'un quatrième masque de résine (10) sur le premier masque dur (6, 60, 61) et sur la couche en matériau semi-conducteur (2), telle que le quatrième masque de résine (10) se superpose sur les bandes (60, 61) du premier masque dur (6), sur les zones extérieures gravées (25, 26) et sur les zones dopées (3, 4) gravées, tout en laissant dégagé l'espace (20) délimité entre elles ;
- gravure partielle de la couche (2) à travers le quatrième masque de résine (10) et le premier masque dur (6, 60, 61) jusqu'à obtenir la hauteur (H₂₀) d'arête (20) entre les deux bandes du premier masque dur (60, 61);
- élimination du quatrième masque de résine (10).

3. Procédé selon la revendication 2, selon lequel la formation du troisième masque de résine (9) est telle qu'il recouvre seulement l'espace (20) délimité entre les deux bandes et en laissant ainsi dégagées la totalité (30 ; 40) des deux zones dopées P et N.

4. Procédé selon la revendication 2, selon lequel l'étape de formation du troisième masque de résine (9) est telle qu'il recouvre à la fois l'espace (20) délimité entre les deux bandes, au moins une partie externe (30, 40) des deux zones dopées P et N et une partie des zones externes (250, 260) de la couche mince de matériau semi-conducteur intrinsèque (2) adjacente à chaque partie externe (30, 40), de manière à ce qu'une fois réalisée lors de l'étape de gravure successive, les parties externes (30, 40) définissent des remontées (30, 40) des zones dopées P et N de hauteur (H₃₀, H₄₀) égale à celle de l'arête (20) ;
le procédé comportant, après l'étape f/ de polissage CMP,
- une étape de formation d'un cinquième masque de résine (13) recouvrant les remontées (30, 40) des zones dopées P et N, les remontées de la couche adjacentes aux remontées (30, 40) des zones dopées qui ne sont pas recouvertes par le deuxième masque dur (12), et se superpose aux zones dopées gravées (3, 4) et aux zones extérieures (25, 26) gravées de la couche (2);
- une étape d'élimination du cinquième masque de résine (13) avant l'étape h/ d'élimination du deuxième masque dur (12).

5. Procédé selon l'une quelconque des revendications précédentes, selon lequel le matériau dur déposé lors de l'étape e/ est le même que celui formant le premier masque dur;

6. Procédé selon l'une des revendications précédentes, selon lequel le premier et/ou deuxième masque(s) dur(s) est (sont) réalisé(s) en un matériau dur choisi parmi la silice, et le nitrure de silicium.

7. Procédé selon l'une des revendications précédentes, selon lequel la couche en matériau semi-conducteur est une couche mince de silicium.

8. Procédé selon l'une des revendications 1 à 7, selon lequel la couche en matériau semi-conducteur est en un matériau semi-conducteur différent du silicium et est formée sur la couche mince de silicium.

9. Procédé selon la revendication 8, selon lequel la couche en matériau semi-conducteur est une couche mince de germanium.
